**Europäisches Patentamt**

**(19) European Patent Office**

**Office européen des brevets**

(11) Publication number : **0 375 665 B1**

# (12) EUROPEAN PATENT SPECIFICATION

(45) Date of publication of patent specification :
**10.03.93 Bulletin 93/10**

(51) Int. Cl.⁵ : **H03K 5/13, H03K 19/086**

(21) Application number : **90103129.4**

(22) Date of filing : **03.08.84**

(54) A pulse delay circuit.

(30) Priority : **05.08.83 US 520876**

(43) Date of publication of application :
**27.06.90 Bulletin 90/26**

(60) Publication number of the earlier application in
accordance with Art. 76 EPC : **0 151 633**

(45) Publication of the grant of the patent :
**10.03.93 Bulletin 93/10**

(84) Designated Contracting States :
**AT BE CH DE FR GB LI LU NL SE**

(56) References cited :
**US-A- 3 431 505**

(73) Proprietor : **ADVANCED MICRO DEVICES, INC.**
**901 Thompson Place P.O. Box 3453**
**Sunnyvale, CA 94088 (US)**

(72) Inventor : **Campbell, David A.**
**934 Honfleur Court**
**Sunnyvale, California 94086 (US)**

(74) Representative : **Wright, Hugh Ronald et al**
**Brookes & Martin 52/54 High Holborn**
**London WC1V 6SE (GB)**

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

## BACKGROUND OF THE INVENTION

### 1. Field of the Invention:

This invention relates to an ECL gate having a controllable fall time and voltage-controlled oscillators utilising such gates, and to phase-locked loops using such oscillators.

### 2. Background of the Invention:

In conventional phase-locked receivers, such as used in data communication systems using Manchester-encoded data signals, the acquisition time for such a receiver to acquire and to lock into a received signal is a predictable function of the receiver's phase-locked loop time constants. These phase-locked loops are usually of the analog type, that is, they use a continuously variable voltage signal for controlling the frequency of the voltage-control oscillator. One particular problem associated with analog phase-locked loop receivers is that phase-lock cannot be obtained if the input signal is precisely out of phase with the receiver local oscillator signal. In applications of phase-locked loops to communication systems, wide loop bandwiths are desirable for acquisition, while much narrower bandwidths are required for tracking.
Previously used techniques, such as switching various capacitors into the circuit, to obtain suitable bandwidths are not suitable and are often impractical to implement in high-speed data communication systems.

Manchester-encoded communication systems are used to communicate digital information because they permit a received signal to be quickly acquired and tracked. Signals encoded in conformity with a Manchester-encoding scheme, are self-clocking, that is, every bit cell of encoded information has a logic-level transition occurring at its midpoint so that a Manchester-encoded signal contains a significant clock frequency component which is separable from the data information. Manchester systems often transmit a preamble prior to actual data information being transmitted so that a receiver can acquire and lock on the input signal and establish a clock reference signal. A system for deriving a clock signal must effectively operate in the presence of noise and jitter.

Many Manchester-encoded data communications systems, such as the Ethernet Local-Area-Network system, are operated intermittently, that is, in stop-and-start applications. Packets of encoded information occur at random intervals, so that there are many time intervals when a signal line is inactive and has only random or impulse noise signals present. A conventional analog phase-locked loop receiver operating under such conditions has difficulty operating because fast acquisition requires wide loop bandwidths while operation with noisy signals requires narrow loop bandwidths which requires a compromise bandwidth to be used.

For integrated circuits, accurate time-delays for pulses, that is, delays controllable to a predetermined time, plus or minus a few percent, are not easily obtained. For fixed delays discrete delay lines have been used.

When relatively long or when variable delays are desired, discrete delay lines have become quite large and difficult to vary. In many digital systems which operate over a range of frequencies, it would be very convenient to have pulse delays which would automatically track with the pulse frequency.

United States Patent Specification 3,431,505 discloses an ECL gate through embodying a capacitor connected between the gate output and a current source, the rate of change of charge in which is controlled by a constant current source, the current through which is determined by a reference voltage shared with the emitter couple pair of transistors of the basic gate. Thus the rate of change of charge in the capacitor can not be changed independently of the switching level of the gate. The paper by AV Kutsenko el al in "Instruments and Experimental Techniques" vol. 16 No. 4 part 1 of July/August 1983 published in New York, USA, discloses the use of inventor gate in a ring to form an oscillator the frequency of which is dependent upon the number of gates utilized and the delay in each gate, but which cannot be otherwise varied or controlled.

This application is divided out of European Patent Application No. 84903136 (Published No. 0151633B). That previous application is directed to an ECL gate having a controllable fall time, voltage controlled oscillators utilising such gates, and to phase-locked loops using such oscillators.

We will describe a circuit embodying the present invention which provides a precise time-delay proportional to the frequency of a reference signal.

The present invention provides a circuit for delaying an input pulse in response to a control signal comprising:

a first emitter-coupled-logic stage having an input terminal for the input pulse and an output terminal for the delayed pulse;

a first delay-timing capacitor coupled between the output terminal of the first ECL stage and a first supply voltage;

a first delay-current source coupled between said output terminal and a second supply voltage;

characterised in that said first delay-current source is a constant current source the current flow of which is variable in response to said control signal which is applied to a control terminal of the current source independently of said first ECL stage, so that the fall of an output signal on said output terminal of said first ECL stage is proportional to said control signal.

Additional objects, advantages and novel features of the invention will be set forth in part in the description which follows, and in part will become apparent to those skilled in the art upon examination of the following or maybe learned by practice of the invention. The objects and advantages of the invention will be realized and obtained by means of the instrumentalities and combinations particularly point out in the appended claims.

Brief Description of the Drawings

The accompanying drawings which are incorporated in the formal part of the specification, illustrate the invention and, together with a description, serve to explain the principles of the invention. In the drawings:

Figure 1 is a block diagram showing a grated ring oscillator using two inverter stages and a gated NOR inverter stage.

Figure 2A is a schematic diagram of an ECL inverter stage.

Figure 2B is an ECL NOR gate stage.

Figure 3 is a schematic diagram of a more complex ECL inverter stage.

Figure 4 is a schematic diagram of a gated voltage-controlled oscillator stage.

Figure 5A is a logic diagram showing a first phase-locked loop circuit receiving a system-reference signal and using a voltage-controlled oscillator.

Figure 5B is a block diagram of a second interruptible phase-locked loop which provides as an output a system-reference clock locked in frequency to the system reference signal and in phase to a received signal.

Figure 6 is a logic diagram of a delay generator according to the invention.

Figure 7 shows voltage waveforms as a function of time at several points in the logic diagram of Figure 6.

Figure 8 is a logic diagram for a Manchester-signal detector according to the invention.

Figure 9 shows waveform diagrams for the logic diagram of Figure 8.

Figure 10 is a schematic diagram of a noninverting delay circuit according to the invention.

Figure 11 is a schematic diagram of an inverting delay generator according to the invention.

5. Detailed Description of the Preferred Embodiments:

Reference is now made in detail to the present preferred embodiments of the invention which illustrate the best mode presently contemplated by the inventor for practicing the invention, the preferred embodiments of which are illustrated in the accompanying drawings.

The inventions described herein are part of a single integrated circuit device identified as the Advanced Micro Devices, Inc., AM7991 Serial Interface Adaptor designed for use in a ten megabit-per-second packet-switched local area network system. This device detects the presence of received data on a transceiver cable and transforms a received Manchester-encoded data signal into a data output signal and a clock output signal. Precision pulse delays, which are locked to the frequency of a reference signal are utilized within this integrated circuit device.

GATED RING OSCILLATOR

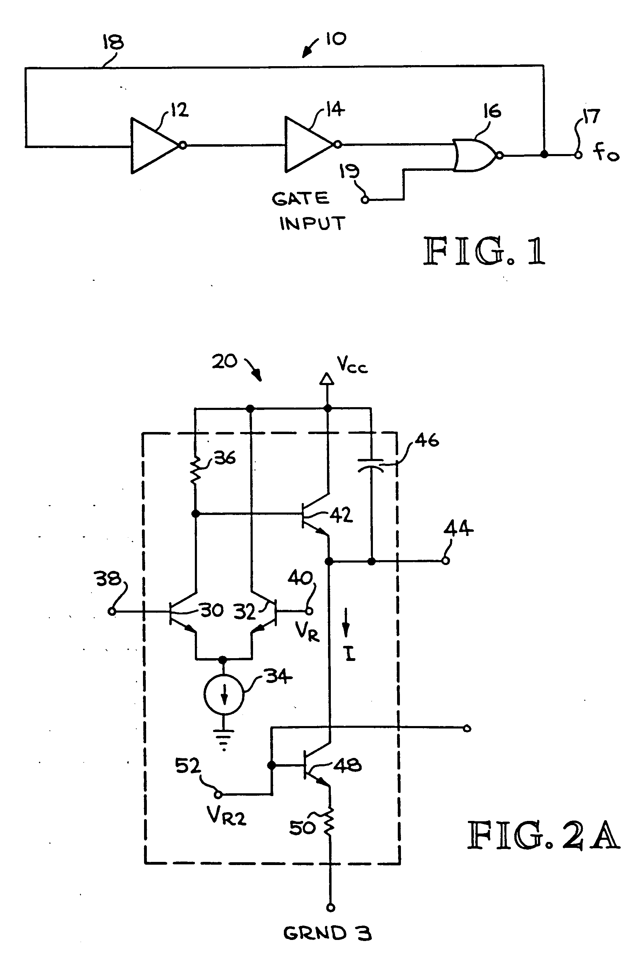

Figure 1 shows a gated ring oscillator circuit comprised of three inverter stages. A first inverter stage 12 and a second inverter stage 14 are cascaded to feed one input terminal of a NOR gate 16 which has its output terminal connected through a signal line 18 to the input of the inverter 12. The other input terminal 19 of the NOR gate 16 is used to gate the ring oscillator circuit on and off. Generally, gated ring oscillators of this type use n inverter stages where n is an odd integer. When the gate input at terminal 19 is low, the oscillator 10 runs with a period of

$$t_p = t_{pLHA} + t_{pHLB} + t_{pLHC} + t_{pHLA} + t_{pLHB} + t_{pHLC}.$$

where $t_{cpLH}$ is the transition time for a gate going from a logical low output state to a logical high output state and where $t_{cpHL}$ is the transition time for a gate going from a high to a low output state.

For equal $t_{cpLH}$ and $t_{cpHL}$, then

$$t_p = 3t_{PLH} + 3t_{PHL}.$$

When the gate input at terminal 19 is high, the output of the NOR gate 16 is forced low so that the output of inverter 14 gives low after a time delay of $2t_{cpHL}+t_{cpLH}$, that is, after the minimum time required for a rising output signal at the output of NOR gate 16 to propogate around the ring. The output signal at terminal 17 for the gated ring oscillator circuit 10 has a frequency $f_0$.

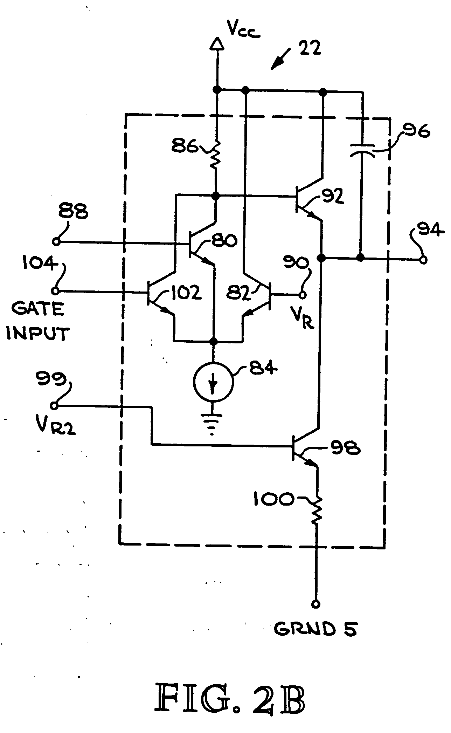

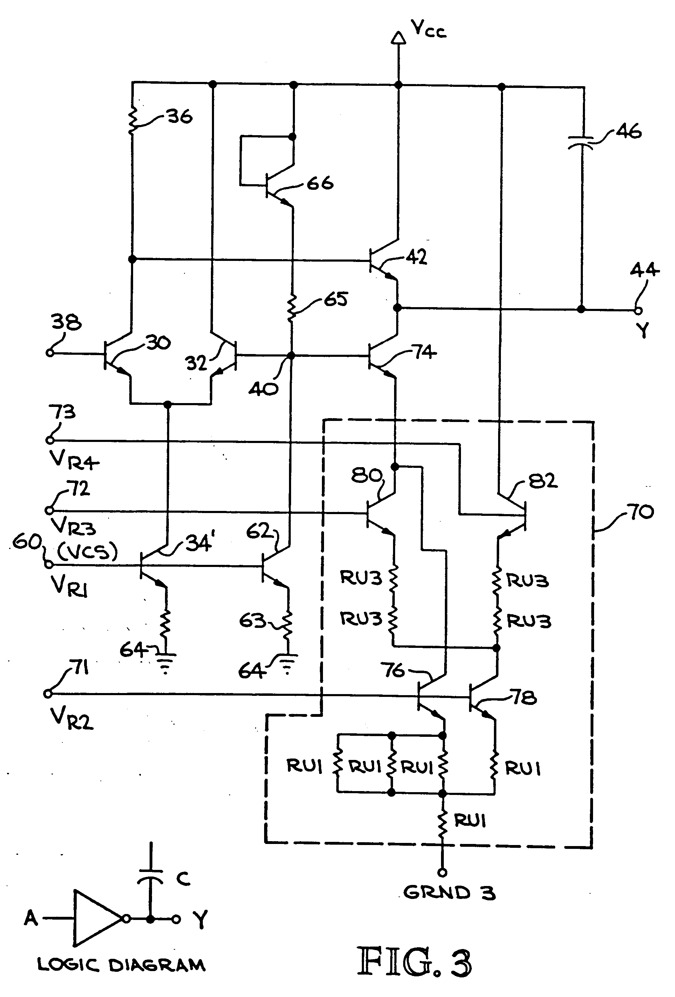

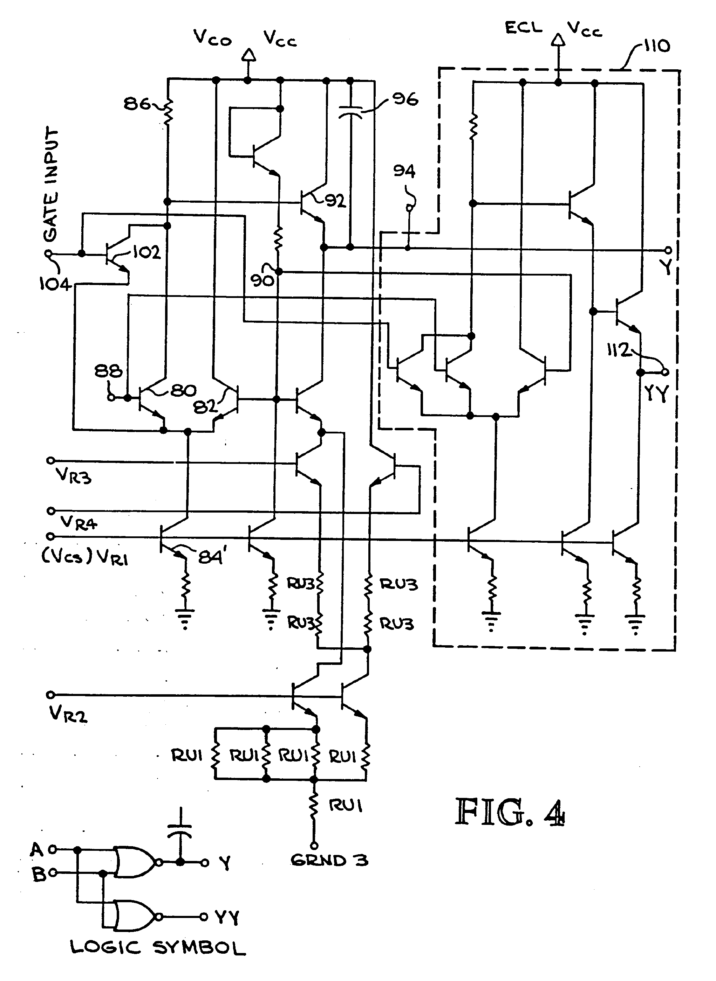

Figure 2A shows a circuit diagram for an emitter-coupled-logic ECL inverter stage 20 and Figure 2B an emitter-coupled ECL NOR gate stage 22 such as used in the ring oscillator of Figure 1. Figure 3 shows a more complex ECL inverter stage while Figure 4 shows a more complex NOR gate.

INVERTER STAGE

Referring to Figure 2A, the inverter stage 20 is an emitter-coupled-logic ECL gate inverter stage circuit having a pair of emitter-coupled transistors 30, 32 having their emitter terminals tied together and supplied with current from a current source 34. Inverting transistor 30 has its collector terminal coupled to a positive voltage supply $V_{cc}$ through a resistor 36. Noninverting transistor 32 has its collector terminal connected directly to the $V_{cc}$ voltage supply. The base terminal of the inverting transistor 30 is connected to an inverter stage input terminal 38, while the gate of the noninverting transistor 32 is connected to a reference voltage, $V_R$, terminal 40. The collector of the transistor 30 is also connected to the base terminal of an output driver transistor 42, which has its collector terminal connected to the $V_{cc}$ voltage supply and which has its emitter terminal connected to an output terminal 44 of the inverter stage. A timing capacitor 46, having a capacitance value considerably larger than the circuit capacitances, is connected between the $V_{cc}$ voltage supply and the emitter terminal of the output driver transistor 42. The gate output terminal 44 is a circuit node from which current is removed through the collector terminal of a current-source transistor 48. The emitter terminal of transistor 48 is coupled to an internal ground GRND3 node through an emitter resistor 50. The base terminal 52 of the current-source transistor 48 is connected to a control input terminal 52 at which is supplied a reference voltage $V_{R2}$ for controlling the current drawn by the current source transistor 48 from the timing capacitor 46.

## INVERTER STAGE OPERATION

Operation of the inverter stage of Figure 2A is as follows:

A logic low level at input terminal 38 turns off transistor 30. The base of output driver transistor 42 is then turned on by current flow from the positive voltage supply $V_{cc}$ through resistor 36 into the base of transistor 42. Except for a small collector-to-emitter voltage drop across transistor 42, output terminal 44 is connected to the $V_{cc}$ voltage level. Transistors 30, 32, 42 are typical for an ECL logic gate and cause output terminal 44 to be quickly connected to $V_{cc}$, typically in much less than a nanosecond. Thus, the so-called rise time for a signal on terminal 44 is very small.

A logic high at input terminal 38 turns on transistor 30, which causes transistor 42 to be turned off, leaving terminal 44 at a voltage near $V_{cc}$. The current-source transistor 48 is set by $V_{R2}$ and emitter-resistor 50 to draw a fixed current away from terminal 40 and thereby linearly draw the voltage at terminal 44 towards the lower potential of GRND3.

The current through transistor 48 is controlled by the control voltage $V_{R2}$ at terminal 52. Thus, it is seen that the so-called fall time of a signal on the output terminal 44 of the inverter stage 20 is controlled by the voltage $V_{R2}$ at terminal 52. Typically, the fall time is on the order of several nanoseconds or more, while the rise time is less than a nanosecond.

## ANOTHER INVERTER STAGE

Figure 3 shows a more complex inverter stage circuit 20, with elements common to Figure 2A having the same reference numerals. A current source transistor 34' provides the same function as the current source 34 of Figure 2A. Terminal 60 connected to the base terminal of the current source transistor 34' has a reference voltage $V_{R1}$ applied thereto to control the current to the emitter-coupled transistor pair 30, 32. $V_{R1}$ is a temperature-compensated voltage which is available, for example, on an integrated circuit. $V_{R1}$ also is a reference voltage for a voltage supply circuit which includes a current-source transistor 62 having its emitter coupled through an emitter resistor 63 to a local ground 64 (corresponding to VR in Figure 2A), having its collector coupled to the reference voltage terminal 40, and then through another resistor 65 and a diode-connector transistor 66 to $V_{cc}$.

Figure 3 includes a more complex current source circuit 70, shown in dotted lines, having control terminals 71, 72 and 73 for controlling the current, nominally 250 microamperes, provided through transistor 74 from output terminal 44. Terminal 71 has a voltage signal $V_{R2}$ applied thereto for controlling the currents through current-source transistors 76, 78 and as will be seen below, to phase-control of one stage of a voltage-controlled oscillator. An increase in voltage $V_{R2}$ increases the current from terminal 44 and would increase the oscillator frequency. Terminal 72 has a voltage signal $V_{R3}$ applied thereto for controlling the current through a transistor 80 which sets the range of frequency adjustment for an oscillator or stage. Terminal 73 has a voltage signal $V_{R4}$ applied thereto which independently controls transistor 82 and an oscillator frequency. Increasing $V_{R4}$ decreases the frequency and is limited in range to 0.75 $f_0$ max and $f_0$ max, where $f_0$ max is the maximum frequency obtained for a particular value of phase-control voltage $V_{R2}$.

An oscillator with an output frequency which is a linear function of current is provided by forming a ring oscillator as in Figure 1. Ignoring base currents and finite current gains and for C46 and other capacitances constant and for fixed voltage levels, the discharging current I is

$$I = I_{74}$$
$$I_{74} = I_{80} + I_{76}$$
$$= I_{80} + 1/2\ I_{78},$$
$$\text{For } V_{R3} = V_{R4} \text{ and } I_{76} = 3I_{78},$$
$$I_{32} = \frac{(V_{52} - Q_{10,11})^4}{5RU1}$$
$$I_{74} = 3/4\ I_{32} + 3/4\ I_{32}(1/6)$$
$$I_{74} = 3/5(1 + 1/6)\frac{(V_{R2} - 0_{10,11})}{RU1}$$

Thus, the discharging current is almost a linear function of the control voltage.

## NOR GATE STAGES

Referring to Figure 2B, a NOR gate circuit 22 corresponding to the NOR gate 16 of Figure 1 is shown. A pair of transistors 80, 82 have their emitter terminals tied together and are fed with current from a current source 84. Transistor 80 is an inverting input transistor which has its collector coupled to the supply voltage $V_{cc}$ through a resistor 86 while a non-inverting transistor 82 has its collector terminal connected directly to the supply voltage $V_{cc}$. The base of the inverting input transistor 80 is connected to an input terminal 88 which can be connected, for example, to the output terminal 44 of the inverter stage 20 as shown in Fig. 2A. The base of the noninverting input transistor 82 is connected to a reference voltage terminal 90 which is supplied a voltage reference $V_r$. An output driver transistor 92 has its base connected to the collector of the inverting input transistor 80. An output terminal 94 has a timing capacitor 96 connected from thence to the $V_{cc}$ voltage supply. The output terminal 94 has current removed therefrom through a collector terminal of a current source 98, which has its emitter coupled through a resistor 100 to the GRND3 terminal. The base of the transistor 98 is connected to terminal 99 which has the voltage reference $V_{R2}$ connected thereto. A second inverting input transistor 102 is connected in parallel to the transistor 80 as shown. The base terminal of the second inverting transistor 102 is connected to a gate input terminal 104 at which is provided a signal for disabling the NOR gate 22.

Figure 4 shows in more detail the circuit diagram for the NOR gate circuit 22 of Figure 2B with the same numerals being used for components common to both circuits. The left hand side of the circuit of Fig. 4 is very similar to the circuit of Fig. 3 with the addition of the second inverting input transistor 102. Fig. 4 also shows a parallel inverter gate circuit 110 without a charging capacitor and having a positive supply voltage ECL VCC and an output YY for interfacing with other logic circuits.

## VCO

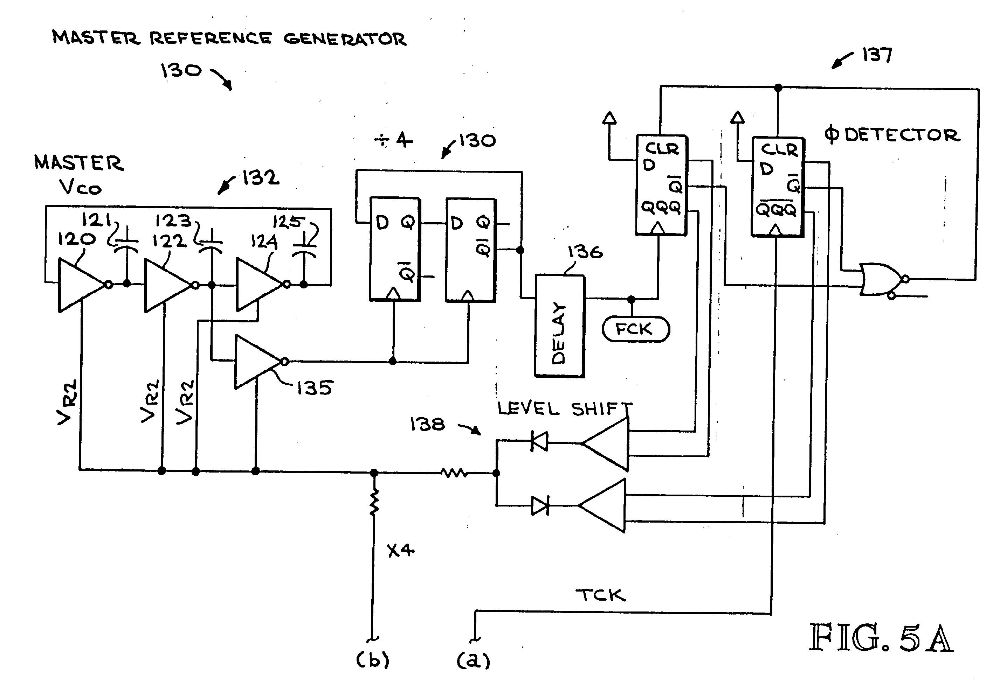

Referring to Figure 5A three inverter stages 120, 122, 124 as described above are shown with timing capacitors 121, 123, 125 in a ring oscillator configuration. With reference to Figures 2A and 3, the inverter turn time $t_{PLH}$, or rise time, is only slightly affected by the timing capacitor. The turnoff time $t_{PLH}$, or fall time, is an inverse linear function of the charging current I into terminal 44. The gate delays and, consequently, the period of a ring oscillator using such inverter stages is determined by (1) the voltage swing from a large high level to the voltage $V_R$ at terminal 40, (2) the magnitude of the discharging current, and (3) the value of the capacitor 46. With capacitor 46 fixed, and the voltage swing fixed, the frequency of an oscillator is a linear function of the charging current I into terminal 44.

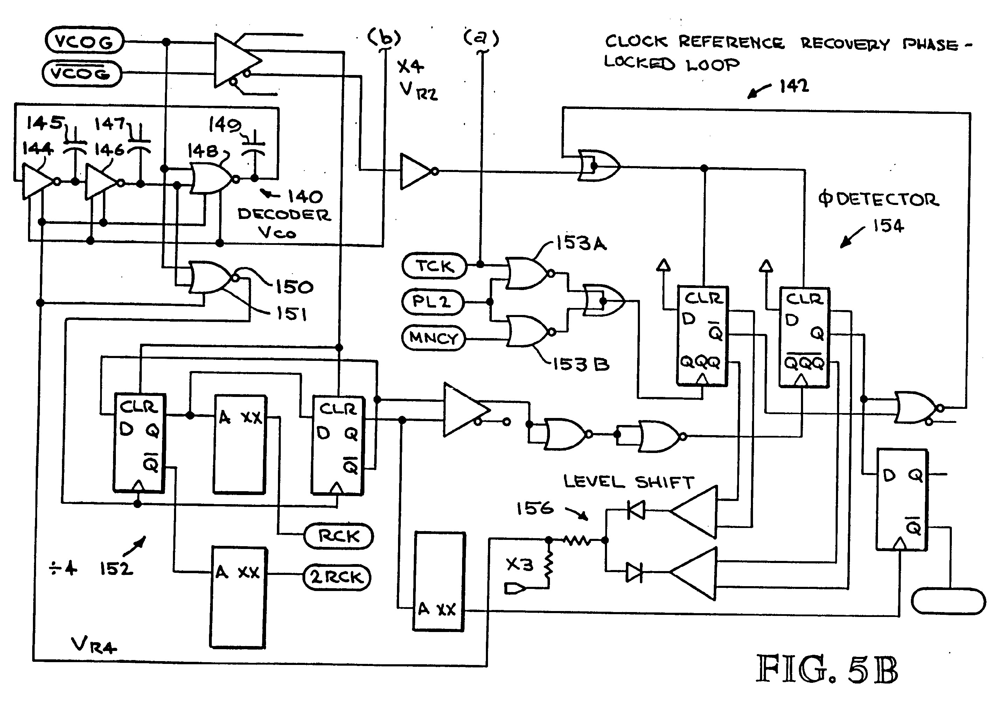

The configuration of Figures 5A and 5B is provided in integrated circuit form to provide, among other things, a voltage-controlled ring oscillator.

In the Advanced Micro Devices, Inc., AM 7991 circuit, used for Manchester-encoders, the ring oscillator operates at 40 MHz and is divided by four to provide clock signals at one-quarter bit intervals. The controlled fall times are 7.6 nanoseconds, the voltage differences are 0.5 volts, and the total fixed and parasitic charging capacitances are 3.8 picofarads.

## PHASE-LOCKED LOOP

Portions of a phase-locked digital data receiver of the AM 7991 circuit are shown a first voltage-controlled oscillator VCO and a second reference VCO provide frequency limits and phase control for a reference frequency signal. This communication receiver has been designed to utilize matched integrated circuit components and is designed to meet the timing and acquisition requirements set forth in various standards. In addition, the recovered reference frequency must not exceed the transmit frequency by 15% under any conditions.

Figures 5A and 5B are the logic diagrams for a clock reference generator for decoding Manchester-encoded data signals. The Master Reference Generator (MRG) circuit 120 or Figure 5A is an analog phase-locked loop which produces a control voltage X4. The MRG 130 includes a VCO 132 having inverters 120, 122, 124, which feeds a divide-by-four circuit 134.

A VCO output buffer stage 135 similar to the parallel inverter circuit 110 of Figure 4 is provided. The edge-triggered D flip-flop divide-by-four circuit 134 divides the output signal which is delayed through a delay circuit 136 to provide a VCO signal FCK to one input of a phase-reference circuit 137. A second input signal TCK to the phase-reference circuit 136 is the transmit reference frequency clock which is provided from a crystal-oscillator source (not shown) for the system. The phase-reference circuit uses two D flip-flops as a pulse-position phase-detector and the D flip-flop output signals are inputted to a phrase correction, level-shaping circuit 138. The output of which is signal X4 which is the VCO voltage control signal corresponding to $V_{R2}$ of Figures 2A, 2B, 3 and 4.

The VR3 and VR4 inputs corresponding to inverter stages 120, 122, 124 are connected together and to an internal bias voltage which is set at one-half the integrated circuit supply voltage $V_{cc}$. Considering the TCK signal as an input and X4 (or $V_{R2}$) as an output, this loop is, then, a frequency-to-voltage converter. It will be seen that X4 is also sued as one of two control voltages for a decoder VCO (DVCO) 140 portion of the clock reference recovery phase-locked loop 142 of Figure 5B.

Referring to Figure 5B, the DVCO 140 is similar to the MRG VCO 132 of Figure 5A. The VR2 terminals for the DVCO are connected to X4 from Figure 5A. VR3 of the DVCO is connected to a separate bias voltage (to minimize cross talk between the two oscillators) set at one-half $V_{cc}$. VR4 for the DVCO is the phase control voltage.

Input logic signals to the DVCO phase-locked loop 142 include a valid received signal detect signal VCOG and a received line actively signal PL2. The transmit clock reference signal, TCK, is crystal-controlled and functions as a system reference signal. The recovered Manchester clock signal MNCK is also provided to the DVCO loop 142.

The clock reference recovery loop 142 includes the decoder VCO 140, controlled in frequency range by VR2 from the VCO 132 of the MRG circuit 130 of Figure 5A. The VCO 140 includes three ECL inverter stages 144, 146, 148, a parallel output inverter 149, and corresponding charging capacitors 145, 147, 149. The output of the VCO circuit 140 is provided from a terminal 150 to a divide-by-four circuit 152 receiver clock RCK to one input of a pulse-position phase circuit 154 which provides an appropriately delayed two-times receiver. The other input to the phase-detector circuit 154 is either the system reference signed transmit clock TCK or the received Manchester clock signal MNCK, as gated by signal PL2 through selection gates 153A and 153B. The output of the phase-detector 154 is level-shifted through level shift circuit 156, which provides a phase-control voltage signal VR4 for the decoder VCO 140. The decoder VCO 140 also receives a frequency-control voltage signal as VR2 from the VCO loop of the MRG circuit 132, which bounds the frequency of the DVCO loop within limits for easy lock-on to a received signal.

Operation of the system is as follows for matched integrated-circuit VCO circuits:

When the received data channel is idle, PL2 is low so that DVCO is locked to TCK. When a signal is detected on the data line, VCOG goes to a logic high level which sets the output of inverter stages 148, 149 low, clears the counter of divider 152 and clears the phase detector 154 stages at the negative clock transition of a Manchester data cell. This clock transition also produces a signal VCOG which enables the incoming clock at the following negative input transition. At the next negative input transition, VCOG goes low restarting DVCO 140 synchronized to this negative input transition and PL2 is enabled to accept clock signals from the incoming data. After a delay to hold the preset count in the stages of the divider 154, the clear input signal thereto is removed from the divider 154 and phase detector 154. DVCO 140 cycles through its first period and the second rising edge at terminal 150 of the parallel stage 149 clocks the divider 152 to produce RCK. The 5th rising edge at terminal 150 is compared to the incoming clock MNCK. A phase-error correction signal for the loop 142 is provided as X3 of $V_{R4}$ of the DVCO 140.

DVCO, then, is locked on the incoming clock MNCK and tracks MNCK from the VCOG high-to-low transition. When the incoming signal stops, PL2 is removed and the DVCO loop 142 resumes tracking TCK.

When connected in a phase-locked loop, the control voltage changes, as needed, to maintain the VCO frequency. Each inverter stage of a VCO provides a precisely controlled fall time.

PRECISE PULSE DELAYS

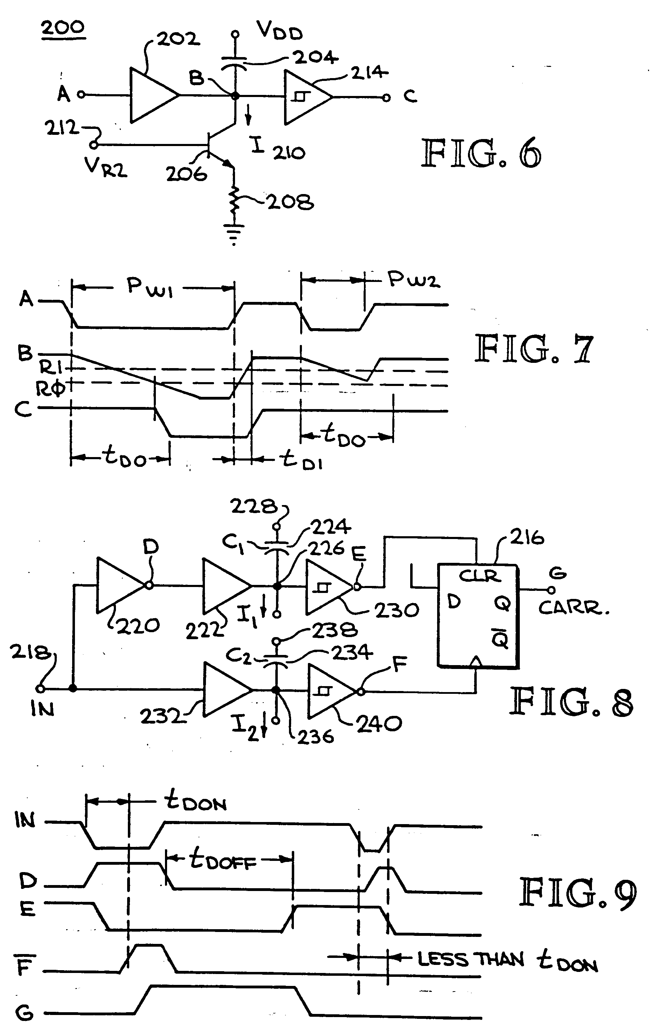

Figure 6 shows a time-delay circuit 200 which is used to generate precise time-delays for pulse signals appearing at an input terminal A thereof. Recall that the control voltage X4 in the phase-locked loop of Figure 5A is very nearly directly proportional to the frequency of the reference signal, that is, as the frequency of the reference signal changes, the control voltage X4 changes. This relationship is used to provide fairly precise delays with accuracies to a predetermined delay of a few percent. To a good approximation the control voltage is proportional to the fall time of a VCO gate stage.

Figure 6 shows a noninverting ECL stage 202 which has an output terminal B with a delay-timing capacitor 204 coupled between thence and a positive supply voltage $V_{DD}$. A delay-current-source transistor 206, has its collector coupled between terminal B and through a resistor 208 to a ground potential. Current $I_{210}$ is controlled by a control voltage VR2 at this base terminal 212 of the current-source transistor 206. As described previously, the fall time of a signal at terminal B is controlled by current $I_{210}$, which is controlled by $V_{R2}$ at terminal 212. If $V_{R2}$ is the control voltage of a phase-locked loop, such as shown in Figure 5A, the fall time of a signal at terminal B is proportional to the frequency of the reference signal into the phase-locked loop.

A hysteresis circuit 214 has its input connected to terminal B and an output signal is provided at terminal C. Voltage waveforms at terminals A, B, and C of figure 6 are shown in Figure 7. A time-delay $t_D$ is found to be inversely proportional to the magnitude of $I_{210}$. Figure 7 shows two input pulses at terminal A, the first having a pulse-width time PW1 and the second having a pulse-width PW2. The hysteresis circuit 214 has an upper threshold voltage R1 and a lower threshold voltage R0 with the hysteresis voltage being the difference therebetween. The first pulse triggers the leading edge of an output pulse at terminal C after a delay of $t_{DO}$. After the pulse-width time PW1 expires, the output pulse trailing edges occurs after a small delay $t_{D1}$, that is after the signal at terminal B exceeds the upper threshold R1.

The second input pulse with a pulse-width PW2 has a duration too short for the signal at terminal B to fall below RO and trigger the hysteresis circuit 214. Consequently, no output pulse at C is produced. The circuit of Figure 6 can thus be used as a pulse-width discriminator, with input pulses at terminal A having a width, or time-duration, of less than a prescribed value not triggering a delayed output pulse at terminal C. Similarly, this circuit can be used to detect that a valid signal is present with a frequency below some predetermined maximum frequency or its complement by cascading two circuits as in Figure 6 to detect pulses within a certain range. When the frequency of a desired signal is known, delay circuits of this type are useful in rejecting out-of-band noise and for detecting the presence of a desired carrier signal.

Figure 8 shows such a combination used in conjucntion with an edge-triggered D flip-flop 216. An input signal IN appears at an input terminal 218 of an ECL inverter stage 220 which has its output terminal coupled to the input terminal of a noninverting ECL inverter stage 222 having an output terminal 226 fed by an appropriate current $I_1$ from a current-source similar to that controlled by VR2 of Figure 6. A C1 capacitor 224 is connected between the output terminal 226 and a positive voltage reference terminal 228. The input of a hysteresis circuit 230 is connected to terminal 226 and the output terminal E of the hysteresis circuit 230 is connected to the clear input CLR of the edge-triggered D flip-flop 216.

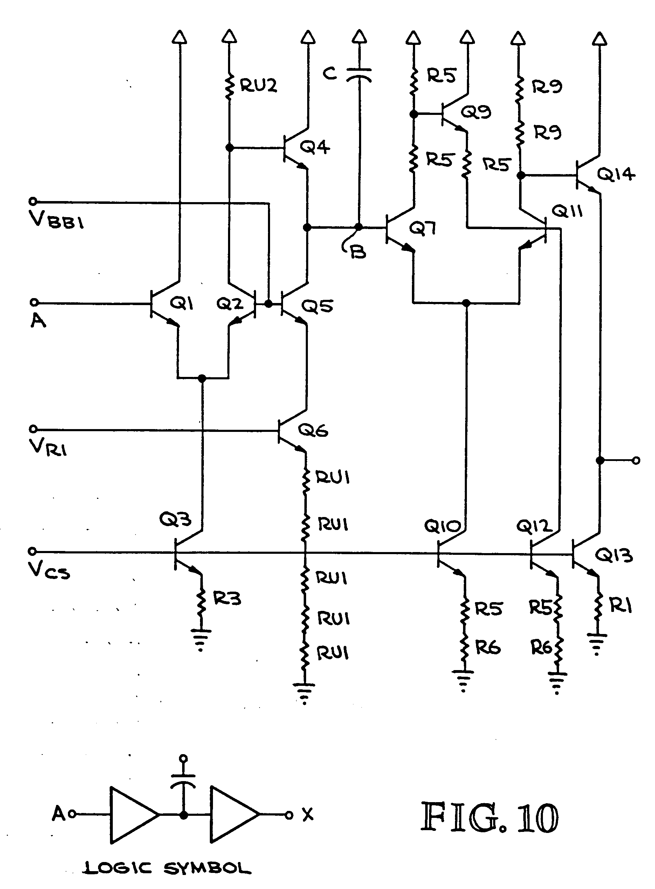

Input terminal 218 is also connected to the input terminal of another ECL noninverting ECL stage 232 having an output terminal 236 fed by another current $I_2$ from a current source. A C2 capacitor 234 is connected between the output terminal 236 and a positive voltage reference terminal 238. The input of another hysteresis circuit 240 is connected to terminal 236 and the output terminal F of the hysteresis circuit 240 is connected to the clock input of the D flip-flop 216 which has a Q output terminal G at which appears a signal CARR for an input pulse signal in having sufficient on-time Figure 9 shows waveforms at various terminals for the circuit of Figure 8.

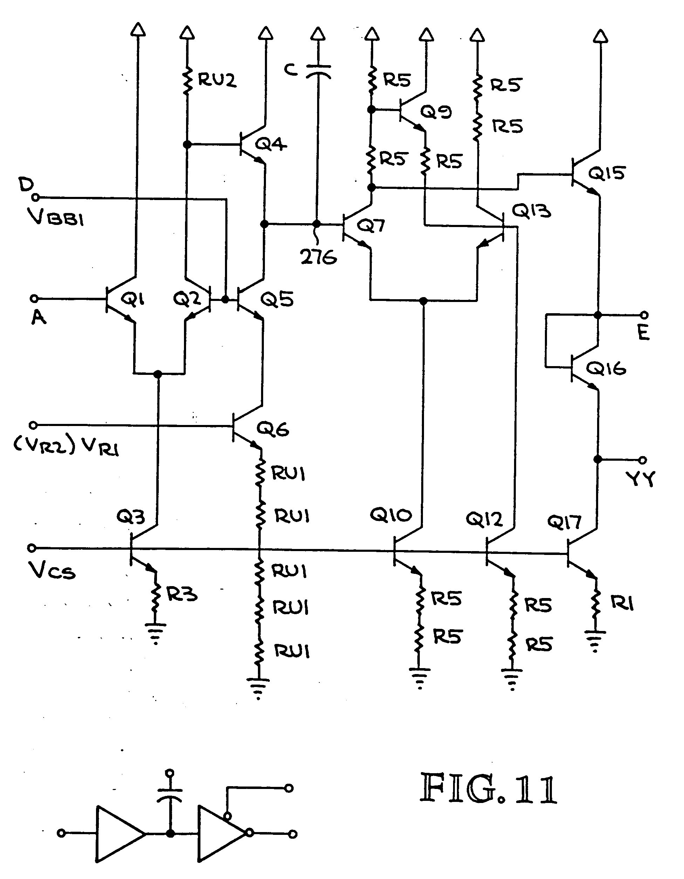

Figures 10 and 11 are circuit diagrams, respectively, for a noninverting and an inverting time delay circuit. The noninverting circuit of Figure 10 corresponds to the logic diagram of Figure 6. The inverting circuit of Figure 11 corresponds to the delay circuits of Figure 8. Similar reference numerals are used in each circuit for similar components. Q1, Q2, Q4, Q5, Q6, and C form an ECL stage similar to those shown in Figure 2A. Q7, Q9 and Q11 form a hysteresis circuit.

Operation of the circuit of Figure 10 is as follows:

Q1 is initially on, Q2 off and the emitter of Q4 high. When input A transitions low Q2 turns on and turns Q4 off. The base of Q7 then charges toward ground at a rate determined by the current through Q5 and C. When the base of Q7 and the base of Q11 approach 0 volts difference, current flow is shifted from Q7 to Q11. Transistor Q9 provides a reference voltage for the base of Q11, and, as conduction starts, in transistor Q11 its threshold is lowered to provide a positive feedback signal to the differential input Q7, Q11. At the onset of current flow in Q11 the feedback signal shifts the threshold of this gate so that the output at the emitter of Q14 switches high to low. The input terminal at A accepts normal logic-voltage swings and the output at the emitter of Q14 provides normal logic-voltage swings. The internal signal at the base of Q4 is 3/2 logic swing. The logic 0 threshold at the base of Q7 is 1 logic swing and the logic 1 threshold is 1/2 logic swing. The hysteresis voltage is 1/2 logic swing and internal noise margins are 1/2 logic swing for any conditions at input terminal A.

The circuit of Figure 11 functions the same as that of Figure 10 except that the output is taken from the collector of Q7 through Q15. This produces a delayed rising output. Diode-connected transistor Q16 provides a level shift to drive lower level ECL inputs.

Delays using these circuits have been fabricated for 20, 35, 112, and 175 nanoseconds. These delay generators have been measured to track design value within ± 2% over the temperature and supply environment of an IC chip.

In summary, the fall time of an ECL gate stage is controlled by the value of a charging capacitor, a controlled pull-down current, and the voltage over which the capacitor charges. A voltage-controlled ring oscillator comprised of ECL gate stages having controlled fall times can be constructed with a wide frequency range. Such an oscillator can be interrupted, or operated in a start-and-stop mode, without affecting the oscillator period. A phase-locked loop constructed of such ECL gate stages serves as a frequency-to-voltage convertor. Two such phase-locked loops are utilized such that the second VCO is independently controlled in phase, but the second VCO is bounded in its frequency range by the first VCO. A Manchester-data decoder using matched VCO circuits has a wide tolerance to noise and provides a clock reference signal for decoding data signals from noisy received signals. Carrier activity on a Manchester-data line is detected using circuits described above. Using precision delay circuits permits descrimination between noise signals and valid signals. Precise pulse delays are obtained which are proportional to the frequency of a reference signal. A Manchester-decoder clock is quickly synchronized in phase by interrupting and starting a VCO. The frequency of a reference clock signal is multiplied. Wide variation of integrated-circuit parameters are tolerated.

## Claims

1. A circuit for delaying an input pulse in response to a control signal comprising:

   a first emitter-coupled-logic (ECL) stage (222) having an input terminal for the input pulse and an output terminal for the delayed pulse;

   a first delay-timing capacitor ($C_1$) coupled between the output terminal of the first ECL stage and a first supply voltage (228);

   a first delay-current source ($I_1$) coupled between said output terminal and a second supply voltage;

   characterised in that said first delay-current source is a constant current source the current flow of which is variable in response to said control signal which is applied to a control terminal (212) of the current source independently of said first ECL stage, so that the fall of an output signal on said output terminal of said first ECL stage is proportional to said control signal.

2. The circuit according to Claim 1, characterised by:

   a first hysteresis circuit (230) having an output terminal and having an input terminal coupled to the output terminal of the first ECL stage said first hysteresis circuit providing at its output terminal a pulse having a width proportional to the control signal.

3. A circuit for discriminating an input pulse width, including the circuit of Claim 2, characterised by;

   a second ECL stage (232) having an input terminal for the input pulse and an output terminal;

   a second-delay-timing capacitor ($C_2$) coupled between the output of the second ECL stage and said first supply voltage;

   a second-delay-current source ($I_2$) coupled between the output of the second ECL stage and the second supply voltage said second delay-current source having a control terminal for varying its output current coupled to said control signal so that the fall time of a signal on the output terminal of the second ECL stage is proportional to said control signal;

   a second hysteresis circuit (240) having an output terminal and having an input terminal coupled to the output terminal of the second ECL stage, said second hysteresis circuit providing at its output terminal a pulse having a variable width proportional to the control signal;

   wherein the first delay-timing capacitor has a larger capacitance value than the second delay-timing capacitor.

4. A circuit according to Claim 3, characterised by an edge-triggered flip-flop circuit (216) having a clock input terminal coupled to the output terminal of the second hysteresis circuit, said edge-triggered flip-flop having a clear terminal (CLR) coupled to the output of the first hysteresis circuit, said flip-flop circuit having an output terminal which is activated in response to an input pulse having a pulse width greater than a predetermined time.

5. A circuit according to Claim 4, characterised in that the input pulse is a Manchester-encoded data signal.

6. A circuit according to any preceding claim, characterised in that said first and second ECL gates each include,

   an output drive transistor (Q4) having its emitter coupled to the gate output, its collector coupled to the first voltage source and its base connected through a resistor (RV2) to the first voltage source,

   a pair of emitter coupled transistors (Q1,Q2) having their emitters connected, while one of the pair has its base connected to an input terminal (A) of the gate and its collector connected to a first collector terminal and the other of the pair has its base connected to a reference voltage source (VBB1) and its collector connected to a second collector terminal,

   the second collector terminal being connected to the base of the drive transistor, and through a resistor to the first voltage source, and the first collector terminal being connected to the first voltage source and,

   the emitters of said emitter coupled pair are connected to said second voltage source through a further constant current device (Q3).

7. A circuit according to any preceding claim, characterised in that the fall time of each ECL stage output is substantially greater than the rise time of that output.

## Patentansprüche

1. Schaltung zum Verzögern eines Eingangsimpulses in Reaktion auf ein Steuersignal, mit:

   - einer ersten emittergekoppelten Logik-ECL-Stufe (222) mit einem Eingangsanschluß für den Eingangsimpuls und einem Ausgangsanschluß für den verzögerten Impuls;

   - einem zwischen dem Ausgangsanschluß der ersten ECL-Stufe und einer ersten Versorgungsspannung (228) gekoppelten ersten Verzögerungszeitgeber-Kondensator ($C_1$):

   - einer zwischen dem Ausgangsanschluß und einer zweiten Versorgungsspannung gekoppelten ersten Verzögerungsstromquelle ($I_1$); dadurch gekennzeichnet, daß die erste Verzögerungsstromquelle eine Konstantstromquelle ist, deren Stromfluß auf das Steuersignal hin variabel ist, welches unabhängig von der ersten ECL-Stufe an einem Steueranschluß (212) der Stromquelle derart anliegt, daß der Abfall eines Ausgangssignal am Ausgangsanschluß der ersten ECL-Stufe proportional zu dem Steuersignal ist.

2. Schaltung nach Anspruch 1, gekennzeichnet durch:
   - eine erste Hystereseschaltung (230) mit einem Ausgangsanschluß und mit einem mit dem Ausgangsanschluß der ersten ECL-Stufe gekoppelten Eingangsanschluß, woobei die erste Hystereseschaltung an ihrem Ausgangsanschluß einen Impuls liefert, dessen Breite proportional zu dem Steuersignal ist.

3. Schaltung zum Diskriminieren einer Eingangsimpulsbreite, mit der Schaltung nach Anspruch 2, gekennzeichnet durch:
   - eine zweite ECL-Stufe (232), die einen Eingangsanschluß für den Eingangsimpuls und einen Ausgangsanschluß aufweist;
   - einen zwischen dem Ausgangsanschiuß der zweiten ECL-Stufe und der ersten Versorgungsspannung (228) gekoppelten zweiten Verzögerungszeitgeber-Kondensator ($C_2$);
   - eine zwischen dem Ausgangsanschluß der zweiten ECL-Stufe und der zweiten Versorgungsspannung gekoppelte zweite Verzögerungsstromquelle ($I_2$), wobei die zweite Verzögerungsstromquelle einen mit dem Steuersignal gekoppelten Steueranschluß zum Variieren ihres Ausgangsstroms aufweist, derart, daß die Abfallzeit eines Signals am Ausgangsanschluß der zweiten ECL-Stufe proportional zu dem Steuersignal ist;
   - eine zweite Hystereseschaltung (240) mit einem Ausgangsanschluß und mit einem mit dem Ausgangsanschluß der zweiten ECL-Stufe gekoppelten Eingangsanschluß, wobei die zweite Hystereseschaltung an ihrem Ausgangsanschluß einen Impuls liefert, dessen variable Breite proportional zu dem Steuersignal ist;
   - wobei der erste Verzögerungszeitgeber-Kondensator einen höheren Kondensatorwert hat als der zweite Verzögerungszeitgeber-Kondensator.

4. Schaltung nach Anspruch 3, gekennzeichnet durch eine flankengesteuerte Flipflopschaltung (216) mit einem Takteingangssignalanschluß, der mit dem Ausgangsanschluß der zweiten Hystereseschaltung gekoppelt ist, wobei das flankengesteuerte Flipflop einen mit dem Ausgangsanschluß der ersten Hystereseschaltung gekoppelten Löschanschluß (CLR) aufweist, und wobei die Flipflopschaltung einen Ausgangsanschluß aufweist, der auf einen Eingangsimpuls mit einer Impulsbreite, die größer ist als eine vorbestimmte Zeit, hin aktiviert wird.

5. Schaltung nach Anspruch 4, dadurch gekennzeichnet, daß der Eingangsimpuls ein manchester-kodiertes Datensignal ist.

6. Schaltung nach einem der vorhergehenden Ansprüche, dadurch gekennzeichnet, daß das erste und das zweite ECL-Gatter jeweils aufweist:
   - einen Ausgangstreibertransistor (Q4), dessen Emitter mit dem Gatterausgang, dessen Kollektor mit der ersten Spannungsquelle und dessen Basis über einen Widerstand (RV2) mit der ersten Spannungsquelle verbunden ist;
   - zwei emittergekoppelte Transistoren (Q1, Q2), deren Emitter verbunden sind, während die Basis eines der beiden Transistoren mit einem Eingangsanschluß (A) des Gatters und der Kollektor dieses Transistors mit einem ersten Kollektoranschluß verbunden ist, und die Basis des anderen der beiden Transistoren mit einer Referenzspannungsquelle (VBB1) und der Kollektor dieses Transistors mit einem zweiten Kollektoranschluß verbunden ist;
   - wobei der zweite Kollektoranschluß mit der Basis des Ansteuerungstransistors und über einen Widerstand mit der ersten Spannungsquelle verbunden ist, und der erste Kollektoranschluß mit der ersten Spannungsquelle verbunden ist, und
   - wobei die Emitter des emittergekoppelten Paares über eine weitere Konstantstromquelle (Q3) mit der zweiten Spannungsquelle verbunden sind.

7. Schaltung nach einem der vorhergehenden Ansprüche, dadurch gekennzeichnet, daß die Abfallzeit jedes ECL-Stufenausgangssignals wesentlich größer ist als die Anstiegszeit dieses Ausgangssignals.

**Revendications**

1. Un circuit destiné à retarder une impulsion d'entrée en réponse à un signal de commande, comportant:
   un premier étage logique à couplage par l'émetteur (ECL) (222) ayant une borne d'entrée pour l'impulsion d'entrée et une borne de sortie pour l'impulsion retardée;

un premier condensateur temporisateur (CI) couplé entre la borne de sortie du premier étage ECL et une première tension d'alimentation (228);

une première source de courant retardé (I1) couplée ladite borne de sortie et une seconde tension d'alimentation;

caractérisé en ce que ladite première source de courant retardé est une source de courant constant dont le débit de courant varie en réponse audit signal de commande appliqué à une borne de commande (212) de la source de courant indépendamment dudit premier étage ECL, afin que la décroissance d'un signal de sortie sur ladite borne de sortie dudit premier étage ECL soit proportionnelle audit signal de commande, et en ce que le premier étage ECL est non-inverseur.

2. Le circuit conforme à la Revendication 1, caractérisé par:

un premier circuit à hystérésis (230) ayant une borne de sortie et ayant une borne d'entrée couplée à la borne de sortie du premier étage ECL, ledit premier circuit à hystérésis fournissant à sa borne de sortie une impulsion d'une largeur proportionnelle au signal de commande.

3. Un circuit de discrimination de largeur d'impulsion d'entrée, comprenant le circuit de la Revendication 2, caractérisé par:

un second étage ECL (232) qui est non-inverseur et qui a une borne d'entrée pour l'impulsion d'entrée et une borne de sortie;

un second condensateur temporisateur (C2) couplé entre la sortie du second étage ECL et ladite première tension d'alimentation;

une seconde source de courant retardé (I2) couplée entre la sortie du second étage ECL et la seconde tension d'alimentation, ladite seconde source de courant retardé ayant une borne de commande pour faire varier son courant de sortie couplée audit signal de commande afin que le temps de décroisssance d'un signal sur la borne de sortie du second étage ECL soit proportionnel audit signal de commande;

un second circuit à hystérésis (240) ayant une borne de sortie et ayant une borne d'entrée couplée à la borne de sortie du second étage ECL, ledit second circuit hysteresis fournissant à sa borne de sortie une impulsion d'une largeur variable proportionnelle au signal de commande;

dans lequel le premier condensateur temporisateur a une capacité supérieure à celle du second condensateur temporisateur.

4. Un circuit conforme à la Revendication 3, caractérisé par un circuit de bascule déclenchée par front d'impulsion (216) ayant une borne d'entrée d'horloge couplée à la borne de sortie du second circuit à hystérésis, ladite bascule ayant une borne de mise à zéro (CLR) couplée à la sortie du premier circuit à hystérésis, ledit circuit de bascule ayant une borne de sortie activée en réponse à une impulsion d'entrée ayant une largeur d'impulsion supérieure à un temps prédéterminé.

5. Un circuit conforme à la Revendication 4, caractérisé en ce que l'impulsion d'entrée est un signal de données à codage Manchester.

6. Un circuit conforme à l'une quelconque des Revendications précédentes, caractérisé en ce que lesdites première et seconde portes ECL comportent chacune,

un transistor de commande final (Q4) ayant son émetteur couplé à la sortie de porte, son collecteur couplé à la première source de tension et sa base reliée à travers une résistance (RV2) à la première source de tension,

une paire de transistors à couplage par l'émetteur (Q1, Q2) ayant leurs émetteurs reliés, tandis que l'un des deux a sa base reliée à une borne d'entrée (A) de la porte et son collecteur relié à une première borne de collecteur et que l'autre a sa base reliée à une source de tension de référence (VBB1) et son collecteur relié à une seconde borne de collecteur,

la seconde borne de collecteur étant reliée à la base du transistor de commande, et à travers une résistance à la première source de tension, et la première borne de collecteur étant reliée à la première source de tension et,

en ce que les émetteurs de ladite paire à couplage par l'émetteur sont reliés à ladite seconde source de tension à travers un dispositif supplémentaire de courant constant (Q3).

7. Un circuit conforme à l'une quelconque des Revendications précédentes, caractérisé en ce que le temps de décroissance de chaque sortie d'étage ECL est sensiblement supérieur au temps de croissance de cette sortie.

FIG. 1

FIG. 2A

FIG. 2B

FIG. 3

LOGIC DIAGRAM

FIG. 4

FIG. 5A

CLOCK REFERENCE RECOVERY PHASE-LOCKED LOOP

FIG. 5B

FIG. 6

FIG. 7

FIG. 8

FIG. 9

FIG. 10

LOGIC SYMBOL

18

FIG. 11